(19) **Europäisches Patentamt / European Patent Office / Office européen des brevets**

(11) **EP 4 063 877 B1**

(12) **FASCICULE DE BREVET EUROPEEN**

(45) Date de publication et mention de la délivrance du brevet:
**01.07.2026 Bulletin 2026/27**

(21) Numéro de dépôt: **22157495.7**

(22) Date de dépôt: **18.02.2022**

(51) Classification Internationale des Brevets (IPC):
**G01R 31/08** (2020.01)　　**G01R 31/58** (2020.01)
**H02H 5/04** (2006.01)

(52) Classification Coopérative des Brevets (CPC):
**G01R 31/58; G01R 31/08; H02H 5/041**

(54) **PROCÉDÉ DE CONTRÔLE D'UN APPAREIL ÉLECTROTECHNIQUE**

VERFAHREN ZUR STEUERUNG EINES ELEKTROTECHNISCHEN GERÄTS

METHOD FOR CONTROLLING AN ELECTROTECHNICAL DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.03.2021 FR 2103011**

(43) Date de publication de la demande:
**28.09.2022 Bulletin 2022/39**

(73) Titulaire: **Schneider Electric Industries SAS 92500 Rueil-Malmaison (FR)**

(72) Inventeurs:
- **CHEVALIER, Marcel**
  **38000 Grenoble (FR)**
- **VAN DOOREN, Didier**
  **38210 Tullins (FR)**

(74) Mandataire: **Schneider Electric Service Propriété Industrielle 35, rue Joseph Monier CS 30323 92506 Rueil-Malmaison Cedex (FR)**

(56) Documents cités:
US-A1- 2011 050 141　　US-A1- 2017 146 586
US-A1- 2018 011 133

## Description

**Domaine technique**

L'invention appartient au domaine des appareils électrotechniques.

**Technique antérieure**

De nombreux appareils électrotechniques, du fait de l'électricité qui les traverse lorsqu'ils sont connectés au réseau électrique, présentent certains dangers à la fois pour le matériel et pour les utilisateurs.

La prévention de ces dangers est importante et passe notamment par des signalisations adaptées pour les utilisateurs. Un des dangers concerne l'état de connexion entre différents éléments constituant le chemin de courant dans les appareils. Cet état de connexion, s'il est dégradé génère des échauffements qui peuvent conduire à des risques de destruction des composants avoisinant, voire générer des incendies.

Le document US2018/011133 décrit une alerte basée sur le calcul d'un facteur de dégradation par comparaison de deux conditions obtenues par mesures de facteur de dissipation sur une phase et de la température.

Il existe différents systèmes de signalisation basés sur des capteurs de mesure de température et alertant d'un danger quand une limite de température est atteinte. Ces systèmes ont l'inconvénient de ne pas prendre en compte l'influence de la température ambiante et du niveau de courant parcourant les connexions et de générer des alertes inutilement.

L'invention vient améliorer cette situation.

**Présentation de l'invention**

A ce titre, l'invention propose un procédé selon la revendication 1 de contrôle d'un appareil électrotechnique, l'appareil électrotechnique comprenant trois phases respectivement connectées à trois phases d'un réseau électrique, le procédé de contrôle comprenant les étapes suivantes :

- mesure, pour chaque phase, d'une pluralité de valeurs de température dans un intervalle de temps déterminé,
- mesure, pour chaque phase, d'une pluralité de valeurs d'intensité du courant dans l'intervalle de temps déterminé,
- détermination, pour chaque phase, d'une pluralité de paramètres spécifiques, chaque paramètre spécifique étant déterminé à partir d'une valeur de température et d'une valeur d'intensité de la phase correspondante mesurées à des instants correspondants de l'intervalle de temps déterminé,
- comparaison de tout ou partie des paramètres spécifiques de la pluralité de paramètres spécifiques des phases sur l'intervalle de temps déterminé,
- détermination d'une alerte sur la base de la comparaison.

Le procédé selon l'invention, par la comparaison des paramètres spécifiques sur un intervalle de temps donné, permet d'alerter sur des causes de dangers futurs pour l'appareil électrotechnique, le réseau électrique et l'utilisateur. En particulier, ces dangers peuvent être prévenus avant qu'ils n'adviennent par une action adaptée. Le procédé permet par exemple de réduire des risques de départs d'incendie dus à une mauvaise connexion entre le réseau et l'appareil électrotechnique.

Optionnellement, les valeurs d'intensité sont des valeurs efficaces d'intensité et les paramètres spécifiques correspondent aux valeurs de température divisés par les carrés des valeurs efficaces d'intensité mesurées aux instants correspondants de l'intervalle de temps déterminé. Dans cette option, les paramètres spécifiques utilisent la température et le carré des valeurs efficaces d'intensité de sorte que les paramètres spécifiques sont une image, ou un équivalent, du point de vue physique, des résistances internes de chaque phase. Cela permet notamment de déterminer des défauts de connexions.

La comparaison comprend la détermination d'une fonction de régression des paramètres spécifiques pour chacune des phases sur l'intervalle de temps déterminé et la comparaison des fonctions de régression. La fonction de régression permet de comparer des comportements de chacune des phases sur l'intervalle de temps déterminé pour identifier des différences entre chacune des phases.

Optionnellement, la comparaison des fonctions de régression comprend la comparaison de coefficients directeurs respectifs, les fonctions étant des fonctions linéaires. La comparaison des coefficients directeurs respectifs permet de déterminer des différences d'évolution des paramètres spécifiques entre chacune des phases sur l'intervalle de temps déterminé.

Optionnellement, une alerte est déterminée sur la base de la comparaison lorsqu'une différence entre un premier coefficient directeur d'une fonction de régression associée à une première phase et un deuxième coefficient directeur d'une fonction de régression associée à une deuxième phase est supérieure à un seuil de coefficient d'alerte déterminé. Cela permet de déterminer une alerte lorsque la différence d'évolution des paramètres spécifiques entre deux phases sur l'intervalle de temps déterminé est supérieure à une valeur seuil.

Optionnellement, une somme des carrés des résidus est déterminée pour chacune des phases à partir de leur fonction de régression linéaire respective. La somme des carrés des résidus des fonctions de régressions linéaire permet notamment de déterminer si une différence de valeurs entre les coefficients directeurs de chacune des fonctions de régression linéaire est due à des variations aléatoires des paramètres spécifiques.

Optionnellement, la fonction de régression d'une phase est déterminée par une méthode des moindres carrés. Cette méthode permet de déterminer une fonction de régression minimisant les écarts entre les paramètres spécifiques de l'intervalle de temps déterminé et leur valeur estimée par la fonction de régression.

Optionnellement, l'alerte déterminée comprend une notification indiquant un possible défaut de connexion entre l'appareil électrotechnique et le réseau électrique ou au sein de l'appareil électrotechnique lui-même. Cela permet par exemple d'avertir l'utilisateur ou un service externe chargé de la maintenance d'un potentiel défaut de connexion entre l'appareil électrotechnique et le réseau électrique.

Optionnellement, l'alerte comprend un identifiant d'une phase sur laquelle un possible défaut de connexion est apparu. Cela permet de cibler une phase soumise à un potentiel défaut de connexion.

Optionnellement, l'alerte comprend un message d'alerte envoyé à un serveur, le message d'alerte comprenant un identifiant de l'appareil électrotechnique et au moins l'un parmi un identifiant d'une phase de l'appareil électrotechnique et une durée de fonctionnement de l'appareil électrotechnique. Cela permet par exemple à un service de maintenance d'évaluer à distance la réalité d'un problème au niveau de l'appareil électrotechnique ou encore de prévenir un service de sécurité d'une entreprise utilisatrice de l'appareil afin de préserver la sécurité de ces employés et de son matériel. Cela permet en outre d'assurer une traçabilité des alertes, lesquels pourront notamment être utilisées par des assurances en cas de défaut de l'appareil électrotechnique. Cela permet également pour le fabricant, l'utilisateur ou encore l'opérateur de maintenance des appareils électrotechniques d'obtenir des données statistiques en fonction des types d'appareils électrotechniques et des alertes reçues.

L'invention porte par ailleurs sur un procédé de traitement de messages d'alerte par un serveur, le procédé comprenant la réception, par le serveur, d'une pluralité de messages d'alerte obtenus à partir d'un procédé adapté présenté ci-dessus, chaque message d'alerte étant associé à un appareil électrotechnique par un identifiant et une durée de fonctionnement, le procédé de traitement comprenant en outre au moins l'une des étapes suivantes :

- identification d'un type d'appareil comprenant un défaut de fabrication à partir des messages d'alerte, et

- détermination d'une fonction de défaut d'un type d'appareil à partir des messages d'alerte.

Cela permet par exemple à un fabricant, un utilisateur ou encore un opérateur de maintenance d'appareils électrotechniques d'identifier des types d'appareils présentant des défauts de fabrication et de déterminer une fonction de défaut d'un type d'appareil électrotechnique à partir des messages d'alerte. Le fabricant d'appareils électrotechniques utilisant le procédé de traitement de messages d'alerte selon l'invention sera par exemple capable d'identifier une chaine de production défaillante ou un composant d'un type d'appareil électrotechnique fragile. Quant à l'utilisateur d'appareils électrotechniques mettant en œuvre le procédé de traitement de messages, il pourra par exemple garantir la sécurité de ses équipes et de ses équipements ou encore identifier des problèmes récurrents sur certains types d'appareils ce qui permettra notamment d'éclairer ses choix dans l'acquisition futures d'autres appareils électrotechniques. L'opérateur de maintenance utilisant le procédé de traitement de message pourra par exemple associer des actions de maintenances aux différentes fonctions de défauts d'un type d'appareils électrotechniques.

Optionnellement, chaque message d'alerte est également associé à une phase de l'appareil électrotechnique identifié et dans lequel le procédé comprend une étape d'identification d'un défaut de fabrication ou de connexion d'une phase d'un type d'appareil à partir des messages d'alerte. Cela permet d'identifier un défaut de fabrication ou de connexion d'une phase d'un type d'appareil.

L'invention porte par ailleurs sur un système électrotechnique comprenant un appareil électrotechnique comprenant trois phases respectivement connectées à trois phases d'un réseau électrique, le système électrotechnique comprenant également au moins trois capteurs de température adaptés pour mesurer une température sur chacune des phases, le système électrotechnique comprenant par ailleurs un calculateur adapté pour commander le système électrotechnique de façon à mettre en œuvre l'un quelconque des procédés de contrôle présentés par la présente divulgation. Le système électrotechnique comprend avantageusement au moins trois moyens de mesure d'intensité adaptés pour mesurer une intensité sur chacune des phases.

L'invention porte en outre sur un dispositif de traitement de données comprenant un calculateur configuré pour mettre en œuvre l'un des procédés de traitement de messages d'alerte décrits par le présent document.

L'invention porte enfin sur un produit programme d'ordinateur comprenant des instructions pour la mise en œuvre de l'un quelconque des procédés ci-dessus lorsqu'il est mis en œuvre par un ordinateur.

## Brève description des dessins

D'autres caractéristiques, détails et avantages apparaîtront à la lecture de la description détaillée ci-après, et à l'analyse du dessin annexé, sur lequel :

**Fig. 1**

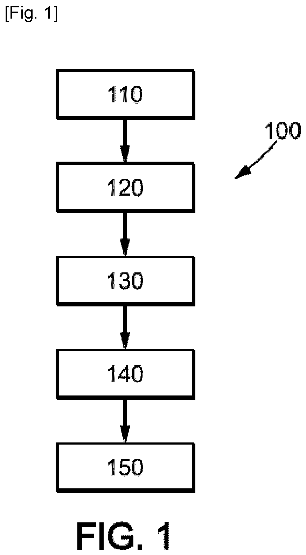

[Fig. 1] représente un exemple de procédé de contrôle d'un appareil électrotechnique.

**Fig. 2**

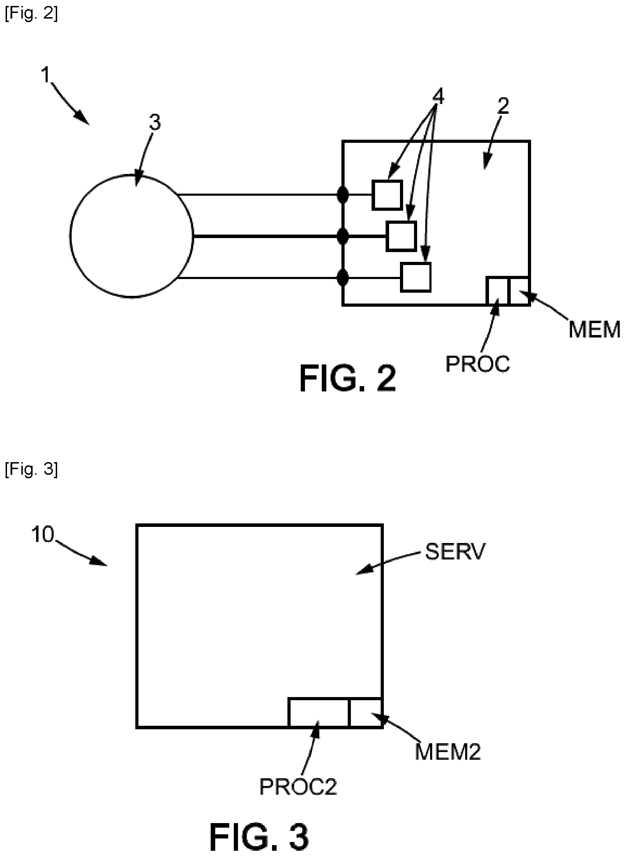

[Fig. 2] représente un exemple de représente un exemple de système électrotechnique.

**Fig. 3**

[Fig. 3] représente un exemple de dispositif de traitement de données.

**Fig. 4**

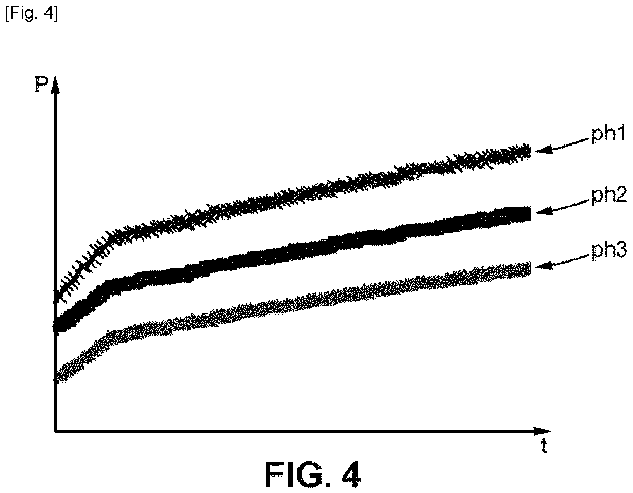

[Fig. 4] représente un exemple d'évolution des paramètres spécifique calculés pour chacune des phases au cours du temps.

**Fig. 5a**

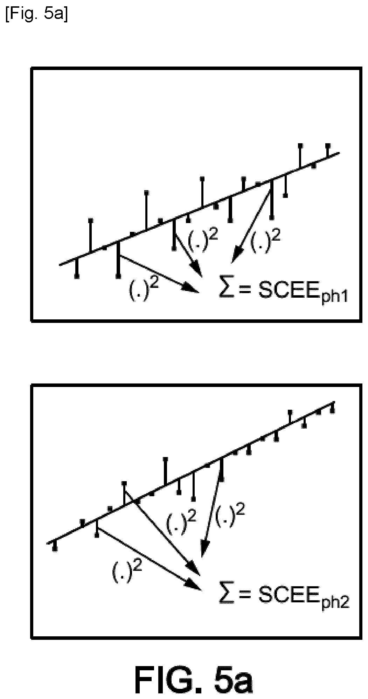

[Fig. 5a] représente en haut une première fonction de régression linéaire associée à une première phase et en bas une première fonction de régression linéaire associée à une deuxième phase.

**Fig. 5b**

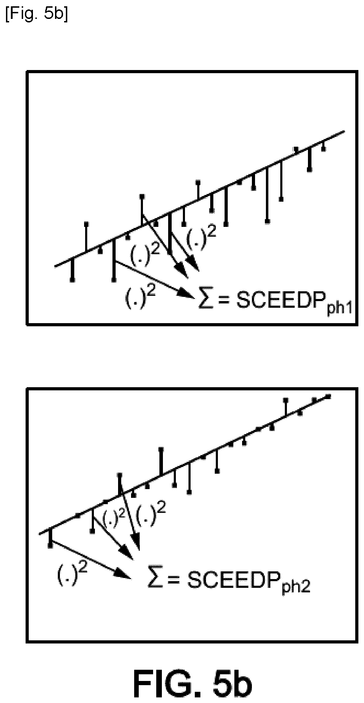

[Fig. 5b] représente en haut des deuxièmes fonctions de régression linéaires associées à une première phase et en bas des deuxièmes fonctions de régression linéaires associée à une deuxième phase.

**Description des modes de réalisation**

Un exemple de système électrotechnique est représenté en figure 2. Cet exemple de système électrotechnique permet notamment la mise en œuvre d'un exemple de procédé 100 de contrôle d'un appareil électrotechnique présenté en figure 1.

Le système électrotechnique 1 comprend un appareil électrotechnique 2. L'électrotechnique se caractérise par un ensemble de techniques relatives aux applications pratiques des phénomènes électriques, magnétiques et électromagnétiques. Dès lors, un appareil électrotechnique au sens de l'invention peut être un appareil mettant en application pratique un phénomène électrique, magnétique ou électromagnétique. Un appareil électrotechnique peut par exemple correspondre à un appareil de coupure tel qu'un disjoncteur, un contacteur ou un interrupteur. Un appareil électrotechnique peut également correspondre à un transformateur, à un moteur alternateur ou encore à une machine-outil.

L'appareil électrotechnique 2 est connecté à un réseau électrique, par exemple à un réseau électrique triphasé 3 comme illustré sur la figure 2. A ce titre, l'appareil électrotechnique 2 comprend trois phases, chacune étant connectée à une phase respective du réseau électrique triphasé 3.

Le système électrotechnique 1 comprend au moins trois capteurs de température 4 adaptés pour mesurer des valeurs de température T sur chacune des phases. Les capteurs de températures peuvent par exemple être disposés à l'intérieur de l'appareil électrotechnique 2 comme représenté sur la figure 1 ou à l'extérieur de cet appareil électrotechnique. Un capteur de température selon l'invention peut par exemple être un capteur thermocouple ou une sonde de température.

Le système électrotechnique 1 comprend des moyens de mesure d'intensité (non représentés) permettant de mesurer des valeurs d'intensité I sur chacune des phases. Les moyens de mesure d'intensité peuvent par exemple correspondre à des ampèremètres disposés sur chacune des phases. En particulier, ces moyens de mesure d'intensité sont adaptés pour mesurer ou estimer des valeurs d'intensité efficace $I_{rms}$ du courant (également connue sous la terminologie « root mean square current » ou « RMS current » en anglais) sur chacune des phases.

Le système électrotechnique 1 comprend également un calculateur PROC adapté pour exécuter des instructions de codes, ces dernières pouvant par exemple être comprises dans une mémoire MEM. Le calculateur PROC est donc connecté à la mémoire MEM de sorte qu'il puisse utiliser de l'information contenue dans la mémoire MEM. La mémoire MEM peut par exemple comprendre des instructions de code pour l'exécution d'un des procédés présentés par la présente demande de telle sorte que le calculateur PROC puisse les exécuter. Le calculateur PROC peut par exemple comprendre un processeur, un contrôleur ou un microcontrôleur. Il peut par exemple être compris dans l'appareil électrotechnique 2 comme illustré par la figure 1.

La mémoire MEM peut par exemple comprendre une mémoire ROM (Read-Only Memory), une mémoire RAM (Random Access Memory), une mémoire EEPROM (Electrically Erasable Programmable Read-Only Memory) ou tout autres types de moyens de stockage adaptés permettant la lecture d'instructions de code. La mémoire MEM peut par exemple comprendre des moyens de stockage optique, électronique ou encore magnétique.

Le calculateur PROC est en outre adapté pour recevoir des données des capteurs de température 4 et des moyens de mesures d'intensité correspondant à des valeurs de température et d'intensité sur chacune des phases. Ces valeurs de température et d'intensité peuvent par exemple être stockées dans la mémoire MEM et/ou envoyées à un serveur SERV.

Comme illustré par le bloc 110 de la Figure 1, l'exemple de procédé 100 de contrôle d'un appareil électrotechnique comprend une mesure, pour chaque phase, d'une pluralité de valeurs de température T dans un intervalle de temps déterminé. Ces mesures sont effectuées par les capteurs de température, par exemple à la suite d'une commande envoyée par le calculateur PROC. Chaque valeur de température est avantageusement associée à un instant à laquelle elle a été mesurée sur l'intervalle de temps déterminé.

Comme illustré par le bloc 120, le procédé 100 comprend une mesure, pour chaque phase, d'une pluralité de valeurs d'intensité I dans l'intervalle de temps déterminé. Ces mesures sont effectuées par les moyens de mesure d'intensité, par exemple à la suite d'une commande envoyée par le calculateur. En particulier, les mesures de valeurs d'intensité peuvent correspondre à des valeurs d'intensité efficace du courant électrique dans chaque phase. Chaque valeur d'intensité est avantageusement associée à un instant à laquelle elle a été mesurée sur l'intervalle de temps déterminé.

Comme dit précédemment, les valeurs de température et d'intensité sont par exemple stockées dans la mémoire MEM et/ou sur un serveur SERV. Elles peuvent par exemple être envoyées au serveur SERV par des canaux de télécommunications tels que des canaux 3G, 4G, filaires, optiques, électromagnétiques, etc.

Le procédé peut être mis en œuvre en temps réel de sorte que, dans des exemples, l'intervalle de temps déterminé peut être un intervalle de temps glissant entre les différentes exécutions du procédé. Dans des exemples, l'intervalle de temps peut être sensiblement le même entre différentes exécutions du procédé. Dans d'autres exemples, une taille de l'intervalle de temps peut être modifiée entre différentes exécutions du procédé. En ce sens, dans des exemples, l'intervalle de temps peut comprendre un nombre de paramètres spécifiques P qui peut ou non varier entre différentes exécutions du procédé. L'intervalle de temps peut par exemple être supérieur à cinq minutes mais il peut également être plus court. Il peut par exemple être de l'ordre d'une ou plusieurs dizaines de minutes. L'intervalle de temps est par exemple compris entre 2 minutes et 180 minutes.

Des valeurs de température et des valeurs d'intensité sont par exemple mesurées au moins toutes les deux minutes pour chaque phase et avantageusement plusieurs fois par minute. Un rythme de mesure plus long des valeurs de température et d'intensité est également envisagé. Un rythme de mesure d'une valeur d'intensité et d'une valeur de température peut par exemple être compris entre une minute et vingt minutes pour chacune des phases.

A la suite des blocs 110 et 120, la mémoire et/ou le serveur comprend donc des mesures représentant une évolution de l'intensité I et de la température T dans chaque phase sur l'intervalle de temps déterminé.

Comme illustré par le bloc 130, le procédé 100 comprend une détermination, pour chaque phase, d'une pluralité de paramètres spécifiques P. Chaque paramètre spécifique P est déterminé à partir d'une valeur de température T et d'une valeur d'intensité I de la phase correspondante mesurées à des instants correspondants de l'intervalle de temps déterminé.

La pluralité de paramètres spécifiques peut par exemple comprendre au moins trente paramètres spécifiques, chacune des phases pouvant par exemple être associée à dix paramètres spécifiques. La pluralité de paramètres spécifiques peut par exemple comprendre entre 24 et 300 paramètres spécifiques et est avantageusement supérieur à 6 paramètres spécifiques. Dans un exemple où une valeur de température et une valeur d'intensité sont mesurées toutes les deux minutes pour chaque phase et que la pluralité de paramètres spécifiques P comprend trente paramètres spécifiques P, l'intervalle de temps déterminé correspond environ à vingt minutes.

Lorsque les valeurs d'intensité mesurées sont des valeurs efficaces d'intensité $I_{rms}$, les paramètres spécifiques peuvent correspondre aux valeurs de température divisées par les carrés des valeurs efficaces d'intensité mesurées aux instants correspondants de l'intervalle de temps déterminé ($P = T/I_{rms}^2$). Cette formule est dérivée de la formule de l'effet Joule reproduite ci-dessous :

[Math. 1]

$$Q = R \int_{t1}^{t2} i^2 \, dt$$

dans laquelle Q correspond à l'énergie dissipée sous forme de chaleur entre deux instants t1 et t2 par un dipôle de résistance R traversé par un courant d'intensité continue i.

Dans la variante où P correspond à $T/I_{rms}^2$, l'énergie dissipée Q sous forme de chaleur entre deux instants est estimée par la valeur de température T mesurée à un instant donné de l'intervalle de temps sur une phase par le capteur de température, l'intensité i étant estimée par l'intensité efficace $I_{rms}$ de sorte que le paramètre spécifique P soit homologue à une résistance interne de la phase.

Une figure illustrant une représentation des paramètres spécifiques P obtenus sur les trois phases dans cette variante est représentée en figure 4. L'axe des abscisses représente le temps t et l'axe des ordonnées représente les valeurs des paramètres spécifiques P. Sur la figure 4, la première phase est référencée ph1, la deuxième phase est référencée ph2 et la troisième phase est référencée ph3.

Comme illustré par le bloc 140, le procédé 100 comprend une comparaison de tout ou partie des paramètres spécifiques de la pluralité de paramètres spécifiques des phases sur l'intervalle de temps déterminé.

La comparaison des paramètres spécifiques des phases sur l'intervalle de temps déterminé peut comprendre une identification d'un comportement différent, c'est-à-dire d'une évolution différente, des paramètres spécifiques P entre deux phases ou d'une phase par rapport aux deux autres sur l'intervalle de temps déterminé. Ainsi, sur la figure 4, on peut identifier que la première phase ph1 se comporte légèrement différemment des deux autres phases. Dès lors que chaque phase est censée se comporter de façon similaire dans un fonctionnement normal, une différence d'évolution des paramètres spécifiques P entre différentes phases sur un même intervalle de temps permet de détecter un problème sur le système électrotechnique.

Ainsi, comme illustré par le bloc 150, le procédé 100 comprend la détermination d'une alerte sur la base de la comparaison de tout ou partie des paramètres spécifiques de la pluralité de paramètres spécifiques des phases sur l'intervalle de temps déterminé.

L'identification d'un comportement différent des paramètres spécifiques P de deux phases ou d'une phase par rapport aux deux autres par la comparaison des paramètres spécifiques P comprend la détermination d'une fonction de régression des paramètres spécifiques P pour chacune des phases sur un intervalle de temps déterminé. En l'occurrence, les comportements des phases sont comparés par couple, c'est-à-dire qu'il est par exemple comparé le comportement de la première phase par rapport à la deuxième phase ou le comportement de la deuxième phase par rapport à la troisième phase ou encore le comportement de la troisième phase par rapport à la première phase.

De cette façon, le procédé permet de déterminer une alerte lorsqu'il constate que deux phases évoluent différemment sur l'intervalle de temps déterminé. Par ailleurs, en comparant tous les couples de phases, le procédé est capable d'identifier une phase défaillante comme étant la phase dont l'évolution diverge des deux autres sur l'intervalle de temps déterminé. Dans ce cas de figure, le procédé permet également d'identifier l'origine de la défaillance.

La fonction de régression des paramètres spécifiques P d'une phase permet de modéliser mathématiquement l'évolution des paramètres spécifiques P de cette phase sur l'intervalle de temps considéré et donc de pouvoir comparer les phases entre elles.

En particulier, les fonctions de régression modélisant l'évolution des paramètres spécifiques P de chaque phase peuvent être des fonctions de régression linéaires (ci-après appelées premières fonctions de régression linéaires pour les différencier des deuxièmes fonctions de régression linéaires qui seront introduites dans une variante de réalisation). Les premières fonctions de régression linéaires des paramètres spécifiques P de chaque phase peuvent ainsi être déterminées par une méthode des moindres carrées. La méthode des moindres carrés entend minimiser la somme des carrés des résidus. Le résidu peut correspondre à l'écart vertical (selon l'axe des ordonnées dans la Figure 4) entre un paramètre spécifique P obtenu à partir d'une mesure de température et d'une mesure d'intensité à un instant donné et sa valeur estimée au même instant par la première fonction de régression linéaire.

Dans le cas où les fonctions de régression sont des premières fonctions de régression linéaires, l'identification de comportements différents des paramètres spécifiques P entre deux phases ou d'une phase par rapport aux deux autres peut comprendre la comparaison des coefficients directeurs respectifs. En effet, la comparaison des coefficients directeurs (i.e. des pentes) des premières fonctions de régression linéaire représente une comparaison de l'évolution des paramètres P au cours du temps sur l'intervalle de temps déterminé.

Ainsi, une alerte est déterminée (bloc 150) sur la base de la comparaison de tout ou partie des paramètres spécifiques P lorsqu'une valeur absolue d'une différence entre un premier coefficient directeur d'une première fonction de régression linéaire associée à une première phase et un deuxième coefficient directeur d'une première fonction de régression linéaire associée à une deuxième phase est supérieure à un seuil de coefficient d'alerte déterminé. Le seuil de coefficient d'alerte peut par exemple correspondre à un pourcentage de différence entre les coefficients directeurs. Les différences entre les coefficients d'alerte doivent être entendues en valeur absolue ici. Avantageusement, le seuil de coefficient d'alerte est inférieur à 10% et de préférence inférieur à 5%. Le seuil de coefficient d'alerte peut être choisi en fonction du nombre de paramètres spécifiques P déterminés dans l'intervalle de temps pour chaque phase. Plus le nombre de paramètres spécifiques est élevé, plus le seuil de coefficient d'alerte peut être proche de 0%.

Par ailleurs, il est possible d'identifier précisément une phase problématique lorsqu'une différence entre son coefficient directeur et le coefficient directeur de chacune des deux autres phases est supérieure au seuil d'alerte alors qu'une différence entre les coefficients directeurs des deux autres phases est inférieure au seuil d'alerte.

Dans une variante, plutôt que de comparer les coefficients directeurs des premières fonctions de régression linaires pour comparer l'évolution des paramètres spécifiques P de deux phases, le procédé va comparer les résidus obtenus à partir des premières fonctions de régressions linéaires de ces deux phases à des résidus obtenus à partir de deuxièmes fonctions de régression linéaires, lesquelles sont notamment obtenues à partir des premières fonctions de régression linéaires de ces deux phases. Les secondes fonctions de régression linéaires peuvent notamment être obtenues à partir des coefficients directeurs des premières fonctions de régression linéaires.

En l'occurrence, il s'agira de déterminer dans la variante si une différence (SCEEDPT- SCEET) entre une deuxième somme totale des carrés des résidus (SCEEDPT) obtenus à partir des deuxièmes fonctions de régression linéaires et une première somme totale (SCEET) des carrés des résidus obtenus à partir des premières fonctions de régressions linéaires est significativement plus importante qu'une différence due à des variations aléatoires. Si c'est le cas, nous pourrons établir que les fonctions de régressions linéaires comparées ne sont pas parallèles, auquel cas, les phases comparées n'évoluent pas de la même façon. Une alerte pourra alors être déterminée.

Ainsi, dans cette variante, il peut être déterminé, pour chacune des phases comparées, une pre-

mière somme SCEE$_{ph}$ des carrés des résidus (l'acronyme SCEE signifiant Somme des Carrés des Ecarts Estimés, les écarts estimés étant les résidus), les résidus correspondant aux écarts verticaux entre les paramètres spécifiques P associés à une phase et leur valeur estimée par la première fonction de régression linéaire associée à cette phase. Cette détermination est représentée sur la figure 5a dans laquelle la première fonction de régression linéaire associée à une première phase est représentée en haut tandis que la première fonction de régression linéaire associée à une deuxième phase est représentée en bas de la figure.

En d'autres termes, pour la première phase, la première somme SCEE$_{ph1}$ des carrés des résidus de la première phase est égale à la somme des écarts verticaux entre les paramètres spécifiques P de la première phase et leur valeur estimée par la première fonction de régression linéaire aux instants correspondants comme représenté sur la figure 5a.

Lorsque les premières fonctions de régression ont été calculées par la méthode des moindres carrés, les premières sommes SCEE$_{ph}$ des carrés des résidus ont déjà été calculées (puisque ces premières sommes SCEE$_{ph}$ ont été minimisées pour trouver les premières fonctions de régression linéaires).

On calcule ainsi une première somme totale SCEET des carrés des résidus (l'acronyme SCEET signifiant Somme des Carrés des Ecarts Estimés Totale), laquelle correspond à une addition des premières sommes SCEE$_{ph}$ des carrés des résidus des deux phases comparées. La première somme totale SCEET des carrés des résidus correspond donc dans l'exemple illustrée en figure 5a à l'addition de la première somme SCEE$_{ph1}$ des carrés des résidus de la première phase et de la première somme SCEE$_{ph2}$ des carrés des résidus de la deuxième phase.

On calcule également un coefficient directeur moyen CD$_m$ des deux phases comparées à partir de leurs premières fonctions de régression linéaire respectives. Le coefficient directeur moyen CD$_m$ correspond à la somme du coefficient directeur respectif des premières fonctions de régression des deux phases comparées, divisée par deux.

Il est ensuite déterminé au moins une deuxième fonction de régression linéaire pour chaque phase comparée à partir des paramètres spécifiques P associés à cette phase et du coefficient directeur moyen des deux phases comparées. En particulier, chacun des coefficients directeurs des deuxièmes fonctions de régression linéaires déterminées est égal au coefficient directeur moyen CD$_m$ des premières fonctions de régression linéaires des deux phases comparées. Seul un paramètre correspondant à l'ordonnée à l'origine des deuxièmes fonctions de régression linéaires est différent entre les deuxièmes fonctions de régression linéaires. Les deuxièmes fonctions de régressions linéaires sont donc toutes parallèles de coefficient directeur moyen et leur paramètre correspondant à l'ordonnée à l'origine est déterminé à partir des paramètres spécifiques P de leur phase.

Il est ensuite déterminé, pour chaque deuxième fonction de régression linéaire, une deuxième somme SCEEDP des carrés des résidus (l'acronyme SCEEDP signifiant Somme des Carrés des Ecarts Estimés des Droites Parallèles), les résidus correspondant aux écarts verticaux entre les paramètres spécifiques P associés à la phase de la deuxième fonction de régression linéaire et leur valeur estimée par cette deuxième fonction de régression linéaire. Une deuxième somme SCEEDP des carrés des résidus d'une deuxième fonction de régression linéaire d'une phase correspond donc à la somme des carrés des écarts verticaux entre les paramètres spécifiques P de la phase et leur valeur estimée par la deuxième fonction de régression linéaire. Il y a donc autant de deuxièmes sommes SCEEDP que de deuxièmes fonctions de régression linéaires.

En l'occurrence, pour chaque phase, il peut être déterminé une deuxième somme totale SCEEDP$_{ph}$ des carrés des résidus associée à une phase correspondant à la somme des carrés des résidus des deuxièmes fonctions de régression linéaires associée à la phase. Cette détermination est représentée en figure 5b où la deuxième somme totale SCEEDP$_{ph1}$ des carrés des résidus associés à la première phase est illustrée en haut tandis que la deuxième somme totale SCEEDP$_{ph2}$ des carrés des résidus associés à la deuxième phase est illustrée en bas.

Il est ensuite calculé une deuxième somme totale SCEEDPT des carrés des résidus (l'acronyme SCEEDP signifiant Somme des Carrés des Ecarts Estimés des Droites Parallèles Totale) correspondant à une addition (SCEEDPT = $\Sigma$SCEEDP) des deuxièmes sommes SCEEDP des carrés des résidus des deuxièmes fonctions de régression linéaires. Cette deuxième somme totale SCEEDPT des carrés des résidus correspond également à une addition des deuxièmes sommes totales SCEEDP$_{ph}$ des carrés des résidus associées aux phases comparés (SCEEDPT = $\Sigma$SCEEDP$_{ph}$). Dans l'exemple illustré, la deuxième somme totale SCEEDPT des carrés des résidus est donc égale à l'addition (SCEEDPT = SCEEDP$_{ph1}$ + SCEEDP$_{ph2}$) de la deuxième somme totale SCEEDP$_{ph1}$ des carrés des résidus associés à la première phase et de la deuxième somme totale SCEEDP$_{ph2}$ des carrés des résidus associés à la deuxième phase.

Il est enfin déterminé si les paramètres spécifiques P des deux phases comparées ont la même évolution sur l'intervalle de temps à partir de la première SCEET et de la deuxième SCEEDPT somme totale des carrés des résidus.

En particulier, il est déterminé une erreur résiduelle de variation de coefficients directeurs Erv correspondant à la différence (SCEEDPT - SCEET) entre la deuxième somme totale des carrés des résidus (SCEEDPT) et la première somme totale (SCEET) des carrés des résidus.

Dans un exemple, une statistique F de Fisher est utilisée à partir de l'erreur résiduelle de variation de coefficients directeurs Erv et de la première somme totale SCEET des carrés des résidus. La statistique F de Fisher peut correspondre à la formule suivante :

[Math. 2]

$$F = \frac{\frac{\text{Erv}}{\text{k}-1}}{\frac{SCEET}{n-2k}}$$

dans laquelle F correspond à la statistique de Fisher avec k-1 et n-2k degrés de liberté,

Erv correspond à l'erreur résiduelle de variation de coefficients directeurs,

k correspond au nombre de deuxièmes fonctions de régression linéaires (k est donc supérieur ou égal à 2),

SCEET correspond à la première somme totale des carrés des résidus des deux phases comparées, et

n correspond au nombre de paramètres spécifiques P des deux phases comparées.

En l'occurrence, quand F est supérieur à un seuil de rejet déterminé, les évolutions des phases comparées sont considérées différentes, auquel cas une alerte (bloc 150) est déterminée. Le seuil de variation peut par exemple être inférieur à 10% et avantageusement inférieur à 6% lorsque F est exprimé en pourcentage. Il est par exemple égal à 5% ou à 1%.

En l'occurrence, en testant les trois phases deux à deux, il est possible de déterminer deux phases présentant une évolution de leurs paramètres spécifiques P respectifs similaires sur l'intervalle de temps et une autre phase qui diffère par rapport aux deux autres. Le procédé est donc capable d'identifier une phase qui ne fonctionne pas correctement. Dans une variante, si aucune des phases ne réagit de la même façon, le procédé est capable d'identifier qu'il y a un problème de fonctionnement du système électrotechnique mais il ne peut pas identifier sur quelles phases se situe le problème. En particulier, dès lors que seulement deux phases évoluent différemment sur l'intervalle de temps, le procédé est capable de déterminer qu'il y a un problème de fonctionnement.

De retour au bloc 150 illustré en figure 1, une alerte déterminée peut comprendre une notification indiquant un possible défaut de connexion entre l'appareil électrotechnique et le réseau électrique. En l'occurrence, les paramètres spécifiques P étant dépendant de la température et de l'intensité de la phase, ils sont liés à la résistance interne des phases qui diffèrent entre les phases notamment du fait de défauts de connexion entre l'appareil électrotechnique et le réseau électrique. L'alerte peut également comprendre un signal sonore ou visuel par exemple à destination des utilisateurs proches du système électrotechnique pour les prévenir d'un potentiel défaut.

Une alerte déterminée peut également comprendre un identifiant d'une phase sur laquelle un possible défaut de connexion est apparu. Comme expliqué ci-dessus, lorsque le procédé est capable de déterminer quelle phase diffère des deux autres, l'alerte déterminée peut également comprendre un identifiant de cette phase. Cela facilitera notamment la maintenance du système électrotechnique.

Le procédé de contrôle d'un appareil électrotechnique selon l'invention permet donc de réduire les risques aussi bien humains que matériels liés à l'utilisation d'un appareil électrotechnique connecté à un réseau électrique. Il permet notamment de prévenir des départs d'incendie liés à un défaut de connexion des phases de l'appareil électrotechnique et du réseau électrique par une détection de ce défaut en amont de l'incendie.

En l'occurrence, l'alerte déterminée peut également comprendre un message d'alerte envoyé à un serveur SERV. Dans ce cas de figure, le message d'alerte peu comprendre au moins l'un parmi un identifiant d'une phase de l'appareil électrotechnique et une durée de fonctionnement de l'appareil électrotechnique. Le message d'alerte peut donc être envoyé à un fabricant, un service de sécurité, un opérateur de maintenance, etc.

La présente divulgation présente également un dispositif de traitement de données 10 adapté pour traiter des messages d'alerte. Ce dispositif 10 est représenté en figure 3.

Le dispositif 10 peut donc comprendre un serveur SERV adapté pour recevoir des messages d'alerte.

Chaque message d'alerte est associé à un appareil électrotechnique par un identifiant et une durée de fonctionnement. Des messages d'alerte peuvent également comprendre une phase de l'appareil électrotechnique identifié. Les messages d'alerte reçus par le serveur peuvent donc identifier une pluralité d'appareils électrotechniques 2 appartenant à une pluralité de systèmes électrotechniques 1. Ces messages d'alerte peuvent être stockés dans une mémoire MEM2 du dispositif de traitement 10. La mémoire MEM2 peut comprendre les mêmes moyens de stockage d'information que la mémoire MEM présenté en référence à la figure 2.

Le serveur SERV peut également être adapté pour recevoir des valeurs de température et des valeurs d'intensité associées à des appareils électrotechniques. Ces valeurs peuvent également être stockées par la mémoire MEM2. Auquel cas, le procédé présenté en référence à la figure 1 peut être commandé au niveau du serveur SERV, par exemple par un processeur PROC2 similaire au processeur PROC et connecté à la mémoire MEM2.

Le processeur PROC2 est également adapté pour exécuter des instructions de codes pour la commande d'un procédé de traitement de messages d'alerte du serveur SERV.

Le procédé de traitement de messages d'alerte peut comprendre une identification d'un type d'appareil comprenant un défaut de fabrication à partir des messages d'alerte. Il est par exemple identifié un type d'appareil électrotechnique comprenant un défaut de fabrication lorsqu'un nombre de messages d'erreurs pour ce type d'appareils dépasse un seuil de défaut de fabrication prédéterminé.

En l'occurrence, dans la mesure où les messages d'alerte comprennent un identifiant de l'appareil électrotechnique, le processeur est capable d'identifier un type d'appareils électrotechniques qui présente de manière régulière des messages d'alerte. Un type d'appareil électrotechnique peut par exemple correspondre ou comprendre un modèle d'appareils électrotechniques, une marque d'appareils électrotechniques ou encore une ligne de production d'appareils électrotechniques.

Le procédé de traitement de messages d'alerte peut également comprendre une détermination d'une fonction de défaut d'un type d'appareils électrotechniques à partir des messages d'alerte. Une fonction de défaut peut par exemple être une fonction statistique d'apparition d'alertes d'un type d'appareils électrotechniques en fonction de son nombre d'heures de fonctionnement. La fonction statistique d'apparition d'alertes peut également comprendre un défaut au niveau d'une phase lorsque les messages d'alerte comprennent un identifiant de phase.

Le procédé de traitement de messages d'alerte peut par ailleurs comprendre une identification d'un défaut de fabrication ou de connexion d'une phase d'un type d'appareil. Lorsque les messages d'alerte comprennent un identifiant de phase, le procédé peut identifier un défaut de fabrication ou de connexion d'une phase d'un type d'appareil. En l'occurrence, un défaut de fabrication ou de connexion d'une phase d'un type d'appareil peut être identifié lorsqu'un nombre de messages d'alerte identifiant une même phase d'un même type d'appareil est supérieur à un seuil de défaut de phase déterminé.

La mise en œuvre du procédé de traitement de messages d'alerte selon l'invention permet donc un traitement statistique des messages d'alerte. Il permet notamment à une personne intéressée d'identifier des défauts de fabrication ou de connexion de types d'appareils électrotechniques et de manière plus précise de certaines phases d'appareils électrotechniques. Il permet en outre de construire des fonctions de défaut de types d'appareils électrotechniques dans le temps et notamment en fonction d'un nombre d'heures de fonctionnement.

**Revendications**

1. Procédé de contrôle d'un appareil électrotechnique, l'appareil électrotechnique comprenant trois phases respectivement connectées à trois phases d'un réseau électrique, le procédé de contrôle comprenant les étapes suivantes :

   - mesure (110), pour chaque phase, d'une pluralité de valeurs de température dans un intervalle de temps déterminé,
   - mesure (120), pour chaque phase, d'une pluralité de valeurs d'intensité du courant dans l'intervalle de temps déterminé,
   - détermination (130), pour chaque phase, d'une pluralité de paramètres spécifiques, chaque paramètre spécifique étant déterminé à partir d'une valeur de température et d'une valeur d'intensité de la phase correspondante mesurées à des instants correspondants de l'intervalle de temps déterminé,
   - comparaison (140) de tout ou partie des paramètres spécifiques de la pluralité de paramètres spécifiques des phases sur l'intervalle de temps déterminé,
   - **caractérisé en ce que** la comparaison comprend la détermination d'une fonction de régression des paramètres spécifiques pour chacune des phases sur l'intervalle de temps déterminé et la comparaison des fonctions de régression entre elles,
   - détermination (150) d'une alerte sur la base de la comparaison.

2. Procédé selon la revendication précédente, dans lequel les valeurs d'intensité sont des valeurs efficaces d'intensité et les paramètres spécifiques correspondent aux valeurs de température divisés par les carrés des valeurs efficaces d'intensité mesurées aux instants correspondants de l'intervalle de temps déterminé.

3. Procédé selon l'une quelconque des revendications précédentes, dans lequel la comparaison des fonctions de régression comprend la comparaison de coefficients directeurs respectifs, les fonctions étant des fonctions linéaires.

4. Procédé selon l'une quelconque des revendications précédentes dans lequel une alerte est déterminée sur la base de la comparaison lorsqu'une différence entre un premier coefficient directeur d'une fonction de régression associée à une première phase et un deuxième coefficient directeur d'une fonction de régression associée à une deuxième phase est supérieure à un seuil de coefficient d'alerte déterminé.

5. Procédé selon la revendication 3, dans lequel une somme des carrés des résidus est déterminée pour chacune des phases à partir de leur fonction de régression linéaire respective.

6. Procédé selon la revendication 1, dans lequel la fonction de régression d'une phase est déterminée par une méthode des moindres carrés.

7. Procédé selon l'une quelconque des revendications précédentes dans lequel l'alerte déterminée comprend une notification indiquant un possible défaut de connexion entre l'appareil électrotechnique et le réseau électrique.

8. Procédé selon la revendication précédente dans lequel l'alerte comprend un identifiant d'une phase sur laquelle un possible défaut de connexion est apparu.

9. Procédé selon l'une quelconque des revendications précédentes dans lequel l'alerte comprend un message d'alerte envoyé à un serveur, le message d'alerte comprenant un identifiant de l'appareil électrotechnique et au moins l'un parmi un identifiant d'une phase de l'appareil électrotechnique et une durée de fonctionnement de l'appareil électrotechnique.

10. Procédé de traitement de messages d'alerte par un serveur, le procédé comprenant la réception, par le serveur, d'une pluralité de messages d'alerte obtenus à partir de procédés selon la revendication 9, chaque message d'alerte étant associé à un appareil électrotechnique par un identifiant et une durée de fonctionnement, le procédé de traitement comprenant en outre au moins l'une des étapes suivantes :

   - identification d'un type d'appareil électrotechnique comprenant un défaut de fabrication à partir des messages d'alerte, et
   - détermination d'une fonction de défaut d'un type d'appareil électrotechnique à partir des messages d'alerte.

11. Procédé de traitement selon la revendication précédente, dans lequel chaque message d'alerte est également associé à une phase de l'appareil électrotechnique identifié et dans lequel le procédé comprend une étape d'identification d'un défaut de fabrication ou de connexion d'une phase d'un type d'appareil à partir des messages d'alerte.

12. Système électrotechnique comprenant un appareil électrotechnique comprenant trois phases respectivement connectées à trois phases d'un réseau électrique, le système électrotechnique comprenant également au moins trois capteurs de température adaptés pour mesurer une température sur chacune des phases, le système électrotechnique comprenant par ailleurs un calculateur adapté pour commander le système électrotechnique selon l'un quelconque des procédés des revendications 1 à 9.

13. Dispositif de traitement de données comprenant un calculateur configuré pour mettre en œuvre le procédé selon l'une des revendications 10 ou 11.

14. Produit programme d'ordinateur comprenant des instructions pour la mise en œuvre de l'un quelconque des procédés ci-dessus lorsqu'il est mis en œuvre par un système selon la revendication 12.

**Patentansprüche**

1. Verfahren zur Steuerung eines elektrotechnischen Geräts, wobei das elektrotechnische Gerät drei Phasen umfasst, die jeweils mit drei Phasen eines elektrischen Netzes verbunden sind, wobei das Steuerungsverfahren die folgenden Schritte umfasst:
Messen (110) für jede Phase einer Mehrzahl von Temperaturwerten innerhalb eines festgelegten Zeitintervalls,

   - Messen (120) für jede Phase einer Mehrzahl von Stromstärkewerten innerhalb des festgelegten Zeitintervalls,
   - Bestimmen (130) für jede Phase einer Mehrzahl spezifischer Parameter, wobei jeder spezifische Parameter aus einem Temperaturwert und einem Stromstärkewert der entsprechenden Phase bestimmt wird, die zu entsprechenden Zeitpunkten innerhalb des festgelegten Zeitintervalls gemessen wurden,
   - Vergleichen (140) aller oder eines Teils der spezifischen Parameter der Mehrzahl von spezifischen Parametern der Phasen über das festgelegte Zeitintervall,
   - Bestimmen (150) eines Alarms auf Grundlage des Vergleichs,
   - **dadurch gekennzeichnet, dass** der Vergleich das Bestimmen einer Regressionsfunktion der spezifischen Parameter für jede der Phasen über das festgelegte Zeitintervall umfasst sowie den Vergleich dieser Regressionsfunktionen untereinander.

2. Verfahren nach dem vorhergehenden Anspruch, wobei die Stromstärkewerte Effektivstromwerte sind und die spezifischen Parameter den Temperaturwerten dividiert durch die Quadrate der Effektivstromwerte entsprechen, die zu den entsprechenden Zeitpunkten des festgelegten Zeitintervalls gemessen wurden.

3. Verfahren nach einem der vorhergehenden Ansprüche, wobei der Vergleich der Regressionsfunktionen den Vergleich der jeweiligen Steigungskoeffizienten umfasst, wobei die Funktionen lineare Funktionen sind.

4. Verfahren nach einem der vorhergehenden Ansprüche, wobei ein Alarm auf Grundlage des Vergleichs bestimmt wird, wenn eine Differenz zwischen einem ersten Steigungskoeffizienten einer Regressionsfunktion, die einer ersten Phase zugeordnet ist, und einem zweiten Steigungskoeffizienten einer Regressionsfunktion, die einer zweiten Phase zugeordnet ist, größer ist als ein festgelegter Alarm-Schwellenwertkoeffizient.

5. Verfahren nach Anspruch 3, wobei für jede der Phasen eine Summe der quadrierten Residuen aus ihrer jeweiligen linearen Regressionsfunktion bestimmt wird.

6. Verfahren nach Anspruch 1, wobei die Regressionsfunktion einer Phase mittels eines Kleinste-Quadrate-Verfahrens bestimmt wird.

7. Verfahren nach einem der vorhergehenden Ansprüche, wobei der angegebene Alarm eine Meldung umfasst, die auf eine mögliche Störung der Verbindung zwischen dem elektrotechnischen Gerät und dem elektrischen Netz hinweist.

8. Verfahren nach dem vorhergehenden Anspruch, wobei der Alarm eine Kennung einer Phase umfasst, auf der eine mögliche Verbindungsstörung aufgetreten ist.

9. Verfahren nach einem der vorhergehenden Ansprüche, wobei der Alarm eine an einen Server gesendete Alarmmeldung umfasst, wobei die Alarmmeldung eine Kennung des elektrotechnischen Geräts sowie mindestens eine der folgenden Angaben umfasst: eine Kennung einer Phase des elektrotechnischen Geräts und eine Betriebszeit des elektrotechnischen Geräts.

10. Verfahren zur Verarbeitung von Alarmmeldungen durch einen Server, wobei das Verfahren umfasst, dass der Server eine Mehrzahl von Alarmmeldungen empfängt, die aus Verfahren nach Anspruch 9 erhalten wurden, wobei jede Alarmmeldung einer elektrotechnischen Vorrichtung mittels einer Kennung und einer Betriebszeit zugeordnet ist, und wobei das Verarbeitungsverfahren ferner mindestens einen der folgenden Schritte umfasst:

     - Identifizieren eines Typs elektrotechnischer Vorrichtungen, die einen Herstellungsfehler aufweisen, auf Grundlage der Alarmmeldungen, und/oder
     - Bestimmen einer Ausfallfunktion eines Typs elektrotechnischer Vorrichtungen aus den Alarmmeldungen.

11. Verfahren nach dem vorhergehenden Anspruch, wobei jede Alarmmeldung ferner einer Phase der identifizierten elektrotechnischen Vorrichtung zugeordnet ist und wobei das Verfahren einen Schritt umfasst zum Identifizieren eines Herstellungs- oder Verbindungsfehlers einer Phase eines Vorrichtungstyps auf Grundlage der Alarmmeldungen.

12. Elektrotechnisches System, umfassend eine elektrotechnische Vorrichtung mit drei Phasen, die jeweils mit drei Phasen eines elektrischen Netzes verbunden sind, wobei das elektrotechnische System ferner mindestens drei Temperatursensoren umfasst, die dazu geeignet sind, auf jeder der Phasen eine Temperatur zu messen, und wobei das elektrotechnische System ferner einen Computer umfasst, der dazu angepasst ist, das elektrotechnische System gemäß einem der Verfahren nach den Ansprüchen 1 bis 9 zu steuern.

13. Datenverarbeitungsvorrichtung, umfassend einen Computer, der dazu konfiguriert ist, das Verfahren nach einem der Ansprüche 10 oder 11 auszuführen.

14. Computerprogrammprodukt, umfassend Anweisungen zur Durchführung eines der oben genannten Verfahren, wenn diese von einem System nach Anspruch 12 ausgeführt werden.

## Claims

1. Method for controlling an electrotechnical device, the electrotechnical device comprising three phases respectively connected to three phases of an electrical network, the control method comprising the following steps: - measurement (110), for each phase, of a plurality of temperature values within a determined time interval,

     - measurement (120), for each phase, of a plurality of current intensity values within the determined time interval,
     - determination (130), for each phase, of a plurality of specific parameters, each specific parameter being determined from a temperature value and an intensity value of the corresponding phase measured at corresponding instants of the determined time interval,
     - comparison (140) of all or part of the specific parameters of the plurality of specific parameters of the phases over the determined time interval,
     - determination (150) of an alert based on the comparison,

- **characterized in that** the comparison includes determining a regression function of the specific parameters for each of the phases over the determined time interval, and comparing the regression functions with each other.

2. A method according to the preceding claim, wherein the intensity values are RMS intensity values and the specific parameters correspond to the temperature values divided by the squares of the RMS intensity values measured at the corresponding instants of the determined time interval.

3. A method according to any one of the preceding claims, wherein the comparison of the regression functions includes the comparison of respective slope coefficients, the functions being linear functions.

4. A method according to any one of the preceding claims, wherein an alert is determined based on the comparison when a difference between a first slope coefficient of a regression function associated with a first phase and a second slope coefficient of a regression function associated with a second phase is greater than a determined alert coefficient threshold.

5. A method according to claim 3, wherein a sum of squared residuals is determined for each of the phases from their respective linear regression function.

6. A method according to claim 1, wherein the regression function of a phase is determined by a least squares method.

7. A method according to any one of the preceding claims, wherein the specified alert includes a notification indicating a possible fault in connection between the electrotechnical device and the electrical network.

8. A method according to the preceding claim, wherein the alert includes an identifier of a phase on which a possible connection fault has occurred.

9. A method according to any one of the preceding claims, wherein the alert comprises an alert message sent to a server, the alert message comprising an identifier of the electrotechnical device and at least one of an identifier of a phase of the electrotechnical device and an operating time of the electrotechnical device.

10. A method for processing alert messages by a server, the method comprising the server receiving a plurality of alert messages obtained from methods according to claim 9, each alert message being associated with an electrotechnical device by an identifier and an operating time, the processing method further comprising at least one of the following steps:

- identification of a type of electrotechnical device containing a manufacturing defect based on warning messages, and
- determination of a fault function of a type of electrotechnical device from the warning messages.

11. Processing method according to the preceding claim, wherein each warning message is also associated with a phase of the identified electrotechnical device and wherein the method includes a step of identifying a manufacturing or connection defect of a phase of a type of device from the warning messages.

12. An electrotechnical system comprising an electrotechnical apparatus comprising three phases respectively connected to three phases of an electrical network, the electrotechnical system also comprising at least three temperature sensors adapted to measure a temperature on each of the phases, the electrotechnical system further comprising a computer adapted to control the electrotechnical system according to any one of the methods of claims 1 to 9.

13. Data processing device comprising a computer configured to implement the method according to one of claims 10 or 11.

14. Product computer program including instructions for the implementation of any of the above processes when implemented by a system according to claim 12.

[Fig. 1]

FIG. 1

[Fig. 2]

**FIG. 2**

[Fig. 3]

**FIG. 3**

[Fig. 4]

FIG. 4

[Fig. 5a]

FIG. 5a

[Fig. 5b]

$\Sigma$ = SCEEDP$_{ph1}$

$\Sigma$ = SCEEDP$_{ph2}$

FIG. 5b

## EP 4 063 877 B1

### RÉFÉRENCES CITÉES DANS LA DESCRIPTION

**Documents brevets cités dans la description**

- US 2018011133 A